(19)

**Europäisches Patentamt**
**European Patent Office**
**Office européen des brevets**

(11)  **EP 4 495 991 A1**

(12)  **EUROPEAN PATENT APPLICATION**
published in accordance with Art. 153(4) EPC

(43)  Date of publication:
**22.01.2025  Bulletin 2025/04**

(21)  Application number: **23770725.2**

(22)  Date of filing: **13.03.2023**

(51)  International Patent Classification (IPC):
$H01L\ 23/36$ (2006.01)        $B32B\ 15/04$ (2006.01)
$B32B\ 15/20$ (2006.01)        $H01L\ 23/12$ (2006.01)
$H05K\ 1/05$ (2006.01)

(52)  Cooperative Patent Classification (CPC):
B32B 15/04; B32B 15/20; H01L 23/12; H01L 23/36;
H05K 1/05

(86)  International application number:
**PCT/JP2023/009595**

(87)  International publication number:
**WO 2023/176770 (21.09.2023 Gazette 2023/38)**

(84)  Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30)  Priority:  **18.03.2022  JP 2022043286**

(71)  Applicants:
• **NOF Corporation**
  **Shibuya-ku**
  **Tokyo 150-6019 (JP)**
• **Kochi Prefectural Public University Corporation**
  **Kochi-shi, Kochi 780-8515 (JP)**

(72)  Inventors:
• **FUJIMURA,Toshinobu**
  **Tsukuba-shi, Ibaraki 300-2635 (JP)**

• **NAKASATO,Katsumi**
  **Tsukuba-shi, Ibaraki 300-2635 (JP)**
• **IIZUKA,Muneaki**
  **Tsukuba-shi, Ibaraki 300-2635 (JP)**
• **SATO,Kyohei**
  **Tsukuba-shi, Ibaraki 300-2635 (JP)**
• **KAWAHARAMURA,Toshiyuki**
  **Kami-shi, Kochi 782-8502 (JP)**
• **FUKUE,Miyabi**
  **Kami-shi, Kochi 782-8502 (JP)**
• **LIU,Li**
  **Kami-shi, Kochi 782-8502 (JP)**

(74)  Representative: **Hoffmann Eitle
Patent- und Rechtsanwälte PartmbB
Arabellastraße 30
81925 München (DE)**

(54)  **HEAT DISSIPATION SUBSTRATE, HEAT DISSIPATION CIRCUIT BOARD, HEAT DISSIPATION MEMBER, AND METHOD FOR MANUFACTURING HEAT DISSIPATION SUBSTRATE**

(57)  Provided is a heat dissipation substrate in which a metal member is provided adjacent to one surface of an insulating layer. The metal member has a material made from copper, a copper alloy, aluminum, or an aluminum alloy and has a sheet shape having a thickness of 0.2-20 mm inclusive. The insulating layer is formed from a first insulating layer and a second insulating layer, and the first insulating layer and the second insulating layer are metal oxide layers including mutually different aluminum oxides. The first insulating layer is the metal oxide layer having a thickness of 0.01-0.2 um inclusive and a porosity of 10% or less. The second insulating layer is the metal oxide layer having a thickness of 0.3-30 um inclusive and a porosity of 10% or less. While being excellent in heat dissipation performance and insulating property, the heat dissipation substrate is excellent in adhesiveness between the metal member and the insulating layer and can be prevented from warping during heating.

FIG. 1

**Description**

TECHNICAL FIELD

The present invention relates to a heat dissipation substrate, a heat dissipation circuit board, a heat dissipation member, and a method for manufacturing the heat dissipation substrate.

BACKGROUND ART

Conventionally, metal heat dissipation members have been used to release heat generated by electronic parts such as semiconductor chips and antennas to the outside of the system. Some of these heat dissipation members are heat dissipation substrates provided with an insulating layer so as not to conduct electricity. As the insulating layer, ceramics formed of metal oxides, thermosetting resins, plastics, and the like are used. Among these, ceramics are excellent in heat resistance and insulation properties, but have a problem of not exhibiting sufficient thermal conductivity to dissipate heat generated by increases in currents typified by recent electric vehicles, or not exhibiting sufficient adhesion between a metal material and the insulating layer.

There are three main reasons why the thermal conductivity of ceramics is not sufficient. The first reason is that it is difficult to process ceramics to thin plates and to plates having a thickness of 150 um or less by a thermal calcination method, the second reason is that the thermal conductivity of adhesives used to paste ceramics to metals decreases, and the third reason is that the ceramics formed by the thermal calcination method have fine air bubbles and the porosity is not low.

In addition, heat dissipation members have been increasingly used at high temperatures in recent years. In a heat dissipation substrate which is a laminate of a metal material and ceramics, since the metal material and ceramics have significantly different thermal expansion properties, the ceramics cannot absorb the internal stress. Thus, there have been failures such as peeling off between the metal material and the ceramics, breakage of the ceramics, or peeling-off of the heat dissipation substrate from a conductive metal layer, a heat sink or the like bonded to the heat dissipation substrate or breakage due to warpage of the heat dissipation substrate.

Therefore, as a ceramic circuit board capable of solving the above problems, ceramic circuit boards described in Patent Documents 1 to 4 are known. For example, Patent Document 1 proposes a ceramic circuit board including metal layers on both surfaces of a ceramic base material, wherein each of the metal layer includes a first metal layer containing aluminum and a second metal layer containing copper from a surface of the metal layer on a side in contact with the ceramic base material. This ceramic circuit board is manufactured by a technique in which ceramics as an insulating layer and a metal material having a two-layer structure are directly joined to each other by pressure-bonding under heating without an adhesive layer interposed therebetween.

Patent Document 2 proposes a metal base substrate in which an alumina layer is formed on aluminum or an aluminum alloy. Further, Patent Document 3 proposes an insulating substrate including an insulating film formed by thermally spraying ceramic powder onto the surface of a conductive base material. In addition, Patent Document 4 proposes a method of forming a conductive metal oxide film on copper, its alloy, or the like.

PRIOR ART DOCUMENTS

PATENT DOCUMENTS

Patent Document 1: JP-A-2019-67804
Patent Document 2: JP-A-2012-212788
Patent Document 3: JP-A-2014-207490
Patent Document 4: JP-A-2018-172793

SUMMARY OF THE INVENTION

PROBLEMS TO BE SOLVED BY THE INVENTION

However, in the configuration of Patent Document 1, since the insulating layer is joined under heating and pressing, the insulating layer cracks in a case of being thin, so the film thickness of the insulating layer is required to be 200 um or more, and there is a problem that the thermal conductivity is poor. Further, warpage during heating and breakage of ceramics are also problems. In the configuration of Patent Document 2, exemplified is a method of forming an alumina layer by anodic oxidation, but it is difficult to control the film thickness and the dielectric breakdown field intensity is insufficient in the anodic oxidation method, so that the alumina layer is required to be 30 to 200 um to maintain insulation properties. Since the alumina layer obtained by the anodic oxidation method has hexagonal columnar cavities, there is a problem that the porosity is high and the thermal conductivity is poor. Further, as for the thermal spraying method proposed in Patent Document 3, since it is difficult to control the film thickness and there is a possibility that pinholes are formed in the insulating film, the thickness of the insulating film is required to be 80 to 300 $\mu$m, the porosity is also high, and the thermal conductivity is not sufficient. Further, warpage during heating and breakage of ceramics are also problems. In addition, in the configuration of Patent Document 4, the target of film formation is only a conductive metal oxide, and there is no description regarding the porosity, denseness, and heat dissipation properties of the resulting metal oxide layer in addition to the insulating film. In addition, even in a case where a metal oxide serving as an insulator is formed on a metal material by the manufacturing method of Patent Document 4, the surface of the metal material serving as a base material is oxidized in the film formation, and cold and heat resistant adhesion force between the metal material and the metal oxide is not sufficient.

The present invention has been made in view of the above circumstances, and an object of the present invention is to provide a heat dissipation substrate excellent in heat dissipation properties and insulation properties, adhesion between a metal material and an insulating layer, and capable of suppressing warpage during heating, and further to provide a heat dissipation circuit board and a heat dissipation member having the heat dissipation substrate, and a method for manufacturing the heat dissipation substrate.

MEANS FOR SOLVING THE PROBLEMS

That is, the present invention relates to a heat dissipation substrate including a metal material provided adjacent to one surface of an insulating layer, wherein a material of the metal material contains copper or a copper alloy, or aluminum or an aluminum alloy, and the metal material has a sheet shape having a thickness of 0.2 mm or more and 20 mm or less, the insulating layer includes: a first insulating layer provided adjacent to the metal material; and a second insulating layer provided adjacent to a surface of the first insulating layer on a side opposite to the metal material, the first insulating layer and the second insulating layer are metal oxide layers different from each other, the first insulating layer is a metal oxide layer containing 90 wt% or more of an aluminum oxide represented by a composition formula 1: AlxOyCz (where Al represents an aluminum atom, O represents an oxygen atom, and C represents a carbon atom; x, y, and z denote a weight ratio, x + y + z = 100, x is 30 or more and 50 or less, y is 40 or more and 60 or less, and z is 3 or more and 25 or less) and having a thickness of 0.01 um or more and 0.2 um or less and a porosity of 10% or less, and the second insulating layer is a metal oxide layer containing 95 wt% or more of an aluminum oxide represented by a composition formula 2: AlxOyCz (where Al represents an aluminum atom, O represents an oxygen atom, and C represents a carbon atom; x, y, and z denotes a weight ratio, x + y + z = 100, x is 30 or more and 55 or less, y is 40 or more and 65 or less, and z is 0 or more and 10 or less) and having a thickness of 0.3 um or more and 30 um or less and a porosity of 10% or less.

As a preferred aspect of the heat dissipation substrate of the present invention, a volume resistivity of the insulating layer may be 100 GΩ·cm or more.

As a preferred aspect of the heat dissipation substrate of the present invention, in a test piece of a heat dissipation substrate in accordance with test methods of coil set and twist for sheets and strips of copper and copper alloys specified by Japan Copper Brass Association (JCBA) T-324:2011, the test piece having a thickness of 0.5 mm, a length of 30 mm, and a width of 5 mm, and having a short side as a fixed end and another short side on an opposite side as a free end, a warpage determined by pressing the fixed end of the test piece against a hot plate at 140°C for 10 minutes, then measuring a maximum distance (V (mm)) between the hot plate and a lower part of the free end, and substituting V into Calculation Formula 1 may be 5% or less:

$$\text{Calculation Formula 1: warpage} = V/30 \times 100 \ (\%).$$

As a preferred aspect of the heat dissipation substrate of the present invention, a surface roughness Ra1 of an interface of the metal material on a side adjacent to the insulating layer may be 1.0 um or less, a surface roughness Ra2 of an interface of the first insulating layer on a side adjacent to the second insulating layer may be 1.0 $\mu$m or less, a surface roughness Ra3 of a surface of the second insulating layer on a side opposite to the first insulating layer may be 0.3 um or less, and Ra1 $\geq$ Ra2 $\geq$ Ra3 or Ra3 > Ra2 $\geq$ Ra1 may be satisfied.

The present invention also relates to a heat dissipation circuit board wherein a conductive metal layer is provided on a surface of the insulating layer of the heat dissipation substrate, on a side opposite to the metal material.

The present invention also relates to a heat dissipation member wherein a heat sink is bonded to the metal material of the heat dissipation substrate via an adhesive or a grease.

The present invention also relates to a method for manufacturing the heat dissipation substrate, the method including a film forming step of reacting a coating liquid containing a salt or a complex of aluminum on a surface of the metal material separately in a first step and a second step to form the insulating layer.

As a preferred aspect of the method for manufacturing a heat dissipation substrate of the present invention, in the film forming step, a mist or a droplet obtained by atomizing or dropletizing the coating liquid may be conveyed to a surface of the metal material with a carrier gas, and then the mist or the droplet may be reacted separately in the first step and the second step in a temperature atmosphere of 230°C or more and 450°C or less.

According to a preferred aspect of the method for manufacturing a heat dissipation substrate of the present invention, the coating liquid may contain 0.2 wt% or more and 20 wt% or less of an aluminum compound, in the first step, the first insulating layer may be formed by heating the aluminum compound in the coating liquid at 230°C or more and 450°C or less, and in the second step, the second insulating layer may be formed by reacting the heated aluminum compound with water and/or ozone.

EFFECT OF THE INVENTION

The heat dissipation substrate of the present invention exhibits high heat dissipation properties and insulation properties since an insulating metal oxide layer having a thin film and a low porosity is formed (directly on) to be adjacent to a metal material, and heat easily moves between the metal material, which is a good conductor of heat, and the metal oxide layer. The metal oxide layer has a two-layer structure, and includes: a first insulating layer having high adhesion by forming a metal bond with a metal material without oxidizing the metal material; and a second insulating layer having high adhesion by forming a covalent bond with the first insulating layer. For this reason, the metal oxide layer and the metal material have high adhesion, and even if the metal oxide layer and the metal material are repeatedly exposed to a high temperature and a low temperature, failures such as peeling off hardly occur without impairing the high adhesion. Further, in the heat dissipation substrate of the present invention, since the metal oxide layer has insulation properties and a small film thickness, and contains an appropriate amount of amorphous carbon, internal stress generated due to thermal change can be absorbed, so that warpage during heating is small. For this reason, the heat dissipation substrate itself hardly cracks during heating or cooling and heating cycle, and thus peeling-off from the conductive metal layer, heat sink or the like bonded to the heat dissipation substrate, or breakage due to warpage of the heat dissipation substrate hardly occurs.

Since the heat dissipation circuit board and the heat dissipation member of the present invention have the heat dissipation substrate described above, the heat dissipation circuit board and the heat dissipation member can have high heat dissipation properties without causing peeling off or breakage even when repeatedly exposed to a high temperature and a low temperature.

The method for manufacturing a heat dissipation substrate according to the present invention includes a film forming step of reacting a coating liquid containing a salt or a complex of aluminum on the surface of the metal material separately in the first step and the second step to form the insulating layer. Therefore, not only an insulating layer having a low porosity and excellent heat dissipation properties can be obtained, but also the insulating layer can be formed in a state in which oxidation of the surface of the metal material is small. It is therefore possible to obtain a heat dissipation substrate, a heat dissipation circuit board, and a heat dissipation member that do not cause peeling off or breakage even when repeatedly exposed to a high temperature and a low temperature.

BRIEF DESCRIPTION OF THE DRAWINGS

Fig. 1 is a cross-sectional view of a heat dissipation substrate according to an embodiment of the present invention.
Fig. 2 is a cross-sectional view of a heat dissipation circuit board according to an embodiment of the present invention.
Fig. 3 is a cross-sectional view of a heat dissipation member according to an embodiment of the present invention.
Fig. 4 is a schematic view of a film forming apparatus for an insulating layer in a method for manufacturing a heat dissipation substrate according to an embodiment of the present invention.
Fig. 5 is a schematic view of an atomizer in the film forming apparatus for an insulating layer in a method for manufacturing a heat dissipation substrate according to an embodiment of the present invention.
Fig. 6 is a schematic view of a mixing chamber in a film forming apparatus for an insulating layer in a method for manufacturing a heat dissipation substrate according to an embodiment of the present invention.
Fig. 7 is a schematic view of a film forming unit in a film forming apparatus for an insulating layer in a method for manufacturing a heat dissipation substrate according to an embodiment of the present invention.

MODE FOR CARRYING OUT THE INVENTION

Hereinafter, a heat dissipation substrate, a heat dissipation circuit board, a heat dissipation member, and a method for manufacturing the heat dissipation substrate according to an embodiment of the present invention will be described with reference to the drawings.

<Heat dissipation substrate>

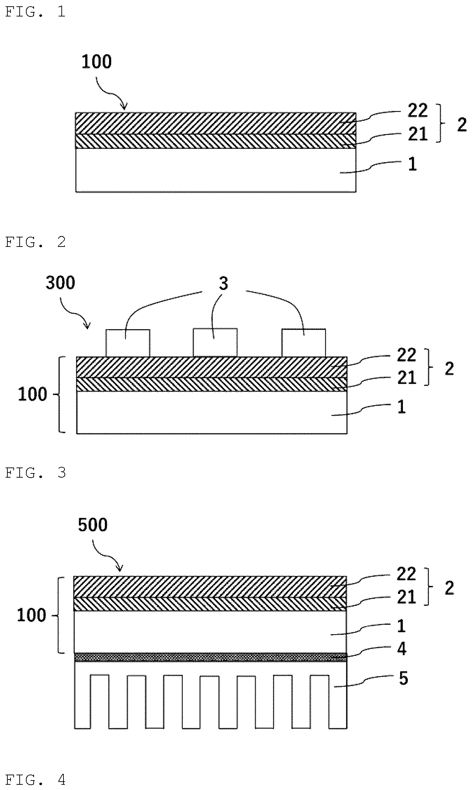

Fig. 1 is a schematic cross-sectional view illustrating a configuration example of a heat dissipation substrate according to an embodiment of the present invention. In a heat dissipation substrate 100 of the present embodiment, a metal material 1 is provided adjacent to one surface of an insulating layer 2. The insulating layer 2 includes a first insulating layer 21 provided adjacent to the metal material 1 and a second insulating layer 22 provided on a surface of the first insulating layer 21 on a side opposite to the metal material 1.

That is, the heat dissipation substrate 100 of the present embodiment is the heat dissipation substrate 100 in which the metal material 1 is provided adjacent to one surface of the insulating layer 2, the material of the metal material 1 contains copper or a copper alloy, or aluminum or an aluminum alloy, and the metal material 1 has a sheet shape with a thickness of 0.2 mm or more and 20 mm or less, and the insulating layer 2 includes the first insulating layer 21 provided adjacent to the metal material 1 and the second insulating layer 22 provided adjacent to the surface of the first insulating layer 21 on a side opposite to the metal material 1. The heat dissipation substrate 100 of the present embodiment is mainly used for dissipating heat generated by electronic parts or the like, and electronic parts such as an antenna, a circuit, or a semiconductor chip is directly mounted on the insulating layer 2, or mounted with an intermediate part interposed therebetween. The metal material 1 is provided to dissipate heat generated by electronic parts or the like. The insulating layer 2 is provided to insulate the electronic parts from the metal material 1 and then transfer heat from the electronic parts to the metal material 1. The metal material 1 may be connected to a heat sink 5, a refrigerant, or the like to be described later in order to further enhance heat dissipation efficiency.

When the heat dissipation substrate 100 is heated to 140°C, it is preferable that the metal material 1 and the insulating layer 2 are not peeled off, and the warpage of the substrate is 5% or less. When the warpage of the heat dissipation substrate 100 is 5% or less, even if parts such as a circuit are mounted on the surface of the insulating layer of the heat dissipation substrate 100, the parts are not broken during heating. The warpage of the heat dissipation substrate 100 is measured in accordance with the "test methods of coil set and twist for sheets and strips of copper and copper alloys (JCBA-T-324: 2011)" specified by Japan Copper Brass Association, standardization committee for electrical parts. Specifically, in a test piece of a heat dissipation substrate having a thickness of 0.5 mm, a length of 30 mm, and a width of 5 mm, a short side of the test piece is defined as a fixed end, and a short side on the opposite side is defined as a free end. The fixed end of the test piece is pressed against a hot plate at 140°C for 10 minutes, and then, a maximum distance (V (mm)) between the hot plate and the lower portion of the free end is measured. The obtained V is substituted into Calculation Formula 1 to thereby calculate the warpage.

$$\mathtt{Warpage\ =\ V/30\ \times\ 100\ (\%)}$$

In JCBA-T-324, the width of the sample is specified to be 10 mm or more, but in the present invention, measurement is performed by setting the width to 5 mm, and a side of 5 mm is referred to as a short side. Further, in JCBA-T-324, the fixed end is specified as a place where an end of a pressing jig in a state of being hung down comes into contact, but in the present invention, measurement is performed while heating with a hot plate. In addition, since the test piece is as short as 30 mm and the influence of the gravity on V is small, measurement is performed on the hot plate in the horizontal state. At this time, the hot plate without distortion is used even at 140°C. Further, JCBA-T-324 specifies that the length of the test piece is 1,000 mm and the test piece is collected so that the longitudinal direction of the sample is parallel to the rolling direction, but in the present invention, the length is set to 30 mm and the direction of collecting the test piece is not limited. In many cases, since the heat dissipation substrate 100 warps in a convex shape toward the metal material 1, measurement is performed so that the metal material 1 is first in contact with the hot plate.

<Metal material>

The material of the metal material 1 is copper or a copper alloy, or aluminum or an aluminum alloy, and the metal material 1 has a sheet shape with a thickness of 0.2 mm or more and 20 mm or less. The metal material 1 and the first insulating layer 21 can exhibit high adhesion as copper atoms or aluminum atoms in the metal material 1 bond directly or via oxygen atoms to aluminum atoms in the insulating layer (metal oxide layer/aluminum compound) at the interface with the insulating layer 2 (first insulating layer 21).

As the copper or copper alloy, or aluminum or aluminum alloy, known one can be applied as long as it exhibits heat dissipation properties as the heat dissipation substrate 100. In a case where high heat dissipation performance is required as the heat dissipation substrate 100, the thermal conductivity of the metal material 1 is preferably 110 W/m·K or more (25°C).

Examples of the copper or copper alloy include a compound represented by the compositional formula: $Cu_xM_yT_z$

(Cu represents a copper atom, M represents a chromium, beryllium, molybdenum, nitrogen, or phosphorus atom, and T represents one atom or a plurality of atoms other than Cu and M. x, y, and z denote a weight ratio, $x + y + z = 100$, x is 60 or more and 100 or less, y is 0 or more and 40 or less, and z is 0 or more and 5 or less.). Here, it is more preferable as the number of copper atoms in the metal material 1 is larger, and x is more preferably 80 or more and 100 or less in a case where high heat dissipation properties are required.

Examples of the aluminum or aluminum alloy include a compound represented by the compositional formula: AlxMyTz (Al represents an aluminum atom, M represents a copper, magnesium, or nitrogen atom, and T represents one atom or a plurality of atoms other than Al and M. x, y, and z denote a weight ratio, $x + y + z = 100$, x is 80 or more and 100 or less, y is 0 or more and 20 or less, and z is 0 or more and 3 or less.). Here, it is more preferable as the number of aluminum atoms in the metal material 1 is larger, and x is more preferably 90 or more and 100 or less in a case where high heat dissipation properties are required.

The compounds represented by the respective compositional formulas have a high thermal conductivity and are more suitable as heat-dissipating materials.

The metal material 1 has a sheet shape with a thickness of 0.2 mm or more and 20 mm or less, preferably 0.5 mm or more and 20 mm or less. The heat dissipation performance is not sufficient in a case where the thickness of the metal material 1 is thinner than 0.2 mm, and there is a disadvantage in the mounting process of a heat dissipation circuit board 300 to be described later when the thickness is larger than 20 mm.

The surface roughness (Ra1) of the metal material 1 on the insulating layer 2 side is preferably 1.0 um or less, and more preferably 0.8 um or less. In a case where the surface roughness (Ra1) is greater than 1.0 um, there is a possibility that the insulating layer 2 cracks when repeatedly exposed to high temperatures. In a case where heat resistance to a temperature of 150°C or more is desired, the surface roughness (Ra1) is more preferably 0.8 um or less.

The metal material 1 is preferably subjected to chemical and/or physical smoothing so that the surface roughness (Ra1) is 1.0 um or less. More preferably, since microscopic chemical changes of the surface of the metal material 1 adversely affect the adhesion to the insulating layer, physical smoothing is preferable. Examples of physical smoothing include buffing to which abrasive grains are added.

In addition, the metal material 1 is oxidized from the surface by being in contact with oxygen to form an oxide layer, and this oxide layer significantly reduces adhesion between the metal material 1 and the insulating layer 2. This decrease in adhesion is considered to be caused by the fact that a metal bond between the copper or aluminum atoms of the metal material 1 and the aluminum atoms of the insulating layer 2 is not formed. The oxide layer preferably has a thickness of 300 nm or less, and in a case of the metal material 1 with an oxide layer thicker than 300 nm, it is preferable to form the insulating layer 2 after removing the oxide layer by chemical treatment and/or physical polishing.

Here, the surface roughness (Ra1) is "arithmetic mean roughness" and refers to a value calculated by measurement using a contact-type surface roughness meter, a laser microscope, an atomic force microscope, or the like. The same applies to the surface roughnesses (Ra2) and (Ra3) to be described later.

<Insulating layer>

The insulating layer 2 includes the first insulating layer 21 provided adjacent to the metal material 1 and the second insulating layer 22 provided adjacent to the surface of the first insulating layer 21 on a side opposite to the metal material 1. The first insulating layer 21 and the second insulating layer 22 are metal oxide layers containing aluminum oxide, and have different elemental compositions of aluminum oxide. That is, the first insulating layer 21 and the second insulating layer 22 are made of metal oxide layers different from each other.

The insulating layer 2 preferably has a volume resistivity of 100 GΩ·cm or more when a DC voltage of 400 V is applied. In this case, electricity at a level at which the circuit undergoes a short circuit at a voltage of 400 V or less does not flow between a conductive metal layer 3 and the metal material 1. The insulating layer 2 more preferably has a volume resistivity of 1,000 GΩ·cm (1 TΩ·cm) or more.

<First insulating layer>

The first insulating layer 21 is a metal oxide layer containing 90 wt% or more of an aluminum oxide represented by a composition formula 1: AlxOyCz (where Al represents an aluminum atom, O represents an oxygen atom, and C represents a carbon atom. x, y, and z denote a weight ratio, $x + y + z = 100$, x is 30 or more and 50 or less, y is 40 or more and 60 or less, and z is 3 or more and 25 or less.), and has a thickness of 0.01 um or more and 0.2 um or less and a porosity of 10% or less. The main component of the carbon atom is derived from amorphous carbon, and when the amount of this component is large, the internal stress due to the expansion difference between the metal material 1 and the insulating layer during heating can be relaxed. In addition, the main component of the oxygen atom is derived from alumina, and when the amount of oxygen atom is small, formation of the oxide layer on the surface of the metal material 1 can be suppressed to enhance adhesion. The copper or aluminum atoms of the metal material 1 and the aluminum atoms of the first insulating layer 21 directly form a metal bond and/or form a covalent bond via an oxygen atom, so that high adhesion can be obtained.

The first insulating layer 21 is an oxide of aluminum containing amorphous carbon, and the first insulating layer 21 represented by the above composition formula has excellent adhesion to the metal material 1 and the second insulating layer 22 as compared with general alumina, and can relax internal stress.

In the composition formula 1, x is preferably 32 or more and 48 or less in a case where the heat dissipation substrate 100 is exposed to a temperature exceeding 200°C for a long time. In a case where x is less than 32, the density of the chemical bond to the metal material 1 and the second insulating layer 22 is reduced, and in a case where x is more than 48, the amount of amorphous carbon with respect to aluminum is reduced. Therefore, peeling off or cracks may occur in the insulating layer 2 when the heat dissipation substrate 100 is exposed to a temperature exceeding 200°C for a long time.

In the composition formula 1, y is preferably 44 or more and 57 or less in a case where the heat dissipation substrate 100 is exposed to a temperature exceeding 200°C for a long time. In a case where y is less than 44, the density of the chemical bond to the second insulating layer 22 is reduced, and in a case where y is more than 57, the amorphous carbon concentration is reduced. Therefore, peeling off or cracks may occur in the insulating layer 2 when the heat dissipation substrate 100 is exposed to a temperature exceeding 200°C for a long time.

In the composition formula 1, z is preferably 5 or more and 25 or less in a case where the heat dissipation substrate 100 is exposed to a temperature exceeding 200°C for a long time. In a case where z is less than 5, the amorphous carbon concentration is reduced, and peeling off or cracking may occur in the insulating layer 2 when the heat dissipation substrate 100 is exposed to a temperature exceeding 200°C for a long time. In a case where z is more than 25, the amount of amorphous carbon in the insulating layer increases, and the insulation properties are significantly lowered.

The first insulating layer 21 contains 90 wt% or more, more preferably 95 wt% or more of the aluminum oxide of the composition formula 1. When the content of the aluminum oxide is less than 90 wt%, adhesion between the metal material 1 and the second insulating layer 22 is lowered. From the viewpoint of preventing a decrease in adhesion due to impurities, the components other than the aluminum oxide are preferably a hydrogen atom, a nitrogen atom, a phosphorus atom, a sulfur atom, a halogen atom, and a combination of these atoms.

The composition ratio of the first insulating layer 21 can be measured by dynamic SIMS or TEM-EELS.

The thickness of the first insulating layer 21 is 0.01 um or more and 0.2 um or less, and in a case where higher adhesion and heat resistance to a temperature exceeding 200°C are required, the thickness is preferably 0.03 um or more and 0.2 um or less. When the thickness is less than 0.01 um, adhesion is poor, and when the thickness is more than 0.2 um, insulation properties are lowered.

The first insulating layer 21 has a porosity of 10% or less. The first insulating layer 21 has a porosity of preferably 5% or less, more preferably 3% or less, still more preferably 1% or less from the viewpoint of enhancing heat dissipation properties. Here, the porosity is a measured value sometimes called pore rate, and is the volume ratio of space occupied by gas in the metal oxide layer. When pores, cracks, voids, and the like are generated in the insulating layer, the value of porosity increases. As the method for measuring the porosity, the Archimedes method, mercury porosimetry, and gravimetric porosimetry are known, and the method is not particularly limited. However, the above-described measurement methods cannot be applied to measure a porosity of 10% or less like the insulating layer (metal oxide layer) of the present embodiment. For this reason, the porosity of 10% or less is determined from the following equation after an electron micrograph of the insulating layer (metal oxide layer) is taken and the area (S1) of the insulating layer (metal oxide layer) and the area of the space (S2) in the same electron micrograph are calculated.

$$\texttt{Porosity = S2} \times \texttt{100/S1 (\%)}$$

The porosity of the second insulating layer 22 is also calculated in the same manner.

The surface roughness (Ra2) of the interface of the first insulating layer 21 on a side adjacent to the second insulating layer 22 is preferably 1.0 um or less, and more preferably 0.7 um or less. In a case where the surface roughness (Ra2) is greater than 1.0 um, there is a possibility that the insulating layer 2 cracks when repeatedly exposed to high temperatures. In a case where heat resistance to a temperature of 150°C or more is desired, the surface roughness (Ra2) is more preferably 0.7 um or less.

<Second insulating layer>

The second insulating layer 22 is a metal oxide layer containing 95 wt% or more of an aluminum oxide represented by a composition formula 2: AlxOyCz (where Al represents an aluminum atom, O represents an oxygen atom, and C represents a carbon atom. x, y, and z denote a weight ratio, x + y + z = 100, x is 30 or more and 55 or less, y is 40 or more and 65 or less, and z is 0 or more and 10 or less.), and has a thickness of 0.3 um or more and 30 um or less and a porosity of 10% or less. The second insulating layer 22 contains alumina as a main component in order to enhance insulation properties and thermal conductivity. The aluminum atoms of the first insulating layer 21 and the aluminum atoms of the second insulating layer 22 form a covalent bond via an oxygen atom, so that high adhesion can be obtained.

The second insulating layer 22 is an oxide of aluminum, and in many cases, the metal oxide layer represented by the above composition formula has high insulation properties with a volume resistivity of 100 GΩ·cm or more.

In the composition formula 2, x is preferably 32 or more, and more preferably 50 or less in a case where insulation properties with a volume resistivity of 1,000 Ω·cm or more are required.

In the composition formula 2, y is preferably 47 or more, and more preferably 60 or less in a case where insulation properties with a volume resistivity of 1,000 Ω·cm or more are required.

In the composition formula 2, the ratio (x/y) of x to y is preferably 0.5 or more and 1.2 or less, and more preferably 0.7 or more and 1.1 or less.

In the composition formula 2, z is preferably 1 or more in a case where the heat dissipation substrate 100 is exposed to a temperature exceeding 200°C for a long time. In addition, in the composition formula 2, z is preferably 8 or less in a case where insulation properties with a volume resistivity of 1,000 Ω·cm or more are required.

The second insulating layer 22 contains 95 wt% or more, more preferably 97 wt% or more of the aluminum oxide of the composition formula 2. When the content of the aluminum oxide is less than 95 wt%, insulation properties and heat dissipation properties are deteriorated. From the viewpoint of preventing a decrease in insulation properties and heat dissipation properties due to impurities, the components other than the aluminum oxide are preferably a hydrogen atom, a nitrogen atom, a phosphorus atom, a sulfur atom, a halogen atom, and a combination of these atoms.

The composition ratio of the second insulating layer 22 can be measured by dynamic SIMS or TEM-EELS.

The second insulating layer 22 has a thickness of 0.3 um or more and 30 um or less, and preferably has a thickness of 0.5 um or more and 10 um or less in a case where higher insulation properties and heat dissipation properties are required. When the thickness is less than 0.3 um, the insulation properties are poor, and when the thickness is more than 30 um, heat dissipation properties are lowered.

The second insulating layer 22 has a porosity of 10% or less. The second insulating layer 22 has a porosity of preferably 5% or less, more preferably 3% or less, still more preferably 1% or less from the viewpoint of enhancing heat dissipation properties.

The surface roughness (Ra3) of the surface of the second insulating layer 22 on a side opposite to the first insulating layer 21 is preferably 0.3 um or less, and more preferably 0.2 um or less. In a case where the surface roughness (Ra3) is greater than 0.3 um, the insulating layer 2 may crack when repeatedly exposed to high temperatures. In a case where heat resistance to a temperature of 150°C or more is desired, the surface roughness (Ra3) is more preferably 0.2 um or less.

Ra1, Ra2, and Ra3 described above preferably satisfy a relationship of Ra1 ≥ Ra2 ≥ Ra3 or Ra3 > Ra2 ≥ Ra1 in a case where the heat dissipation substrate 100 is exposed to a temperature exceeding 200°C for a long time. In a case where a circuit is formed on the surface of the insulating layer of the heat dissipation substrate 100 of the present embodiment, it is particularly preferable to satisfy a relationship of 0.7 ≥ Ra1 ≥ Ra2 > Ra3 because the heat dissipation circuit board 300 having high adhesion in suppressing disconnection of the circuit during heating can be obtained.

In the insulating layer 2, the first insulating layer 21 preferably contains more carbon atoms than the second insulating layer 22, and the first insulating layer 21 preferably contains less oxygen atoms than the second insulating layer 22. The first insulating layer 21 preferably contains more carbon atoms than the second insulating layer 22 in order to enhance adhesion between the first insulating layer 21 and the metal material 1.

<Method for manufacturing heat dissipation substrate>

The method for forming the insulating layer 2 is not particularly limited, and examples thereof preferably include physical vapor deposition methods such as vacuum deposition, ion plating, and sputtering, chemical vapor deposition methods such as plasma CVD, atomic layer deposition (ALD), organometallic CVD, and mist CVD, and coating methods in which a coating liquid is reacted on the metal material 1, such as spraying, ink jetting, spin coating, and dip coating in order to achieve a porosity of 10% or less. Among these, chemical vapor deposition methods and coating methods are preferable since the methods are excellent in film formation speed and uniform film formation.

In the chemical vapor deposition method and the coating method, it is preferable to form a metal oxide layer by heating and reacting a coating liquid containing a salt or a complex of aluminum on the metal material 1 in a temperature atmosphere of 230°C to 450°C. When the temperature for film formation exceeds 450°C, the thermal load on the metal material 1 is large and the dimensional stability of the obtained heat dissipation circuit board 300 deteriorate as well as the difference in coefficient of thermal expansion between the metal material 1 and the insulating layer 2 is large and the metal oxide layer may crack after the temperature thereof is returned to room temperature.

The method for manufacturing the heat dissipation substrate 100 preferably includes a film forming step of reacting a coating liquid containing a salt or a complex of aluminum on the surface of the metal material 1 separately in the first step and the second step to form the insulating layer.

The salt or complex of aluminum is not particularly limited, but aluminum tris(acetylacetonate), aluminum ethyl acetoacetate diisopropylate, aluminum tris(ethylacetoacetate), aluminum monoacetylacetonate bis(ethylacetoacetate), and the like are preferably used. Preferable examples of the oxygen source include water or alcohol, urea, oxygen, and ozone. Here, the oxygen source is a supply source of oxygen atoms for converting an aluminum salt or aluminum complex into alumina.

In the first step, it is preferable not to use an oxygen source, or to use a smaller amount of oxygen source than in the second step. When the amount of the oxygen source is reduced as compared with the first step, surface oxidation of the metal material 1 can be prevented, and further, the amount of amorphous carbon increases. As a result, adhesion among the first insulating layer 21, the metal material 1, and the second insulating layer 22 increases, and the heat dissipation substrate 100 having high heat resistance can be obtained. In the first step, the solvent of the coating liquid is preferably one that does not become an oxygen source, and specifically, one that does not contain water or alcohol is preferable.

In the second step, it is preferable to use an oxygen source in an amount such that the reaction proceeds at a number ratio between aluminum atoms and oxygen atoms of 0.3 to 0.7. When the number ratio is within the above range, the insulation properties and heat resistance of the resulting heat dissipation substrate 100 are enhanced.

As the method for manufacturing the heat dissipation substrate 100 of the present embodiment, a method (hereinafter, abbreviated as mCVD) is more preferable in which mist or droplets obtained by atomizing or dropletizing the coating liquid in the film forming step are conveyed onto the surface of the metal material 1 with a carrier gas, and then the mist or droplets are reacted separately in the first step and the second step in a temperature atmosphere of 230°C or more and 450°C or less. This method is one kind of chemical vapor deposition method. In this way, by forming a coating liquid containing a salt or a complex of aluminum into fine droplets and reacting the fine droplets to form a film on the metal material 1 having a thin and uniform film thickness, a porosity of 3% or less, and a surface roughness (Ra1) of 1.0 um or less, a metal oxide layer having a surface roughness (Ra3) of 0.3 um or less is obtained. According to this method, since the reactivity of the aluminum salt or aluminum complex in the coating liquid is increased by atomization or misting, the metal oxide layer can be obtained at a temperature of 230°C to 450°C, so that a film can be formed without deteriorating the metal material 1, and a metal oxide layer having a high volume resistivity is obtained. Further, by forming a film in a temperature range of 230 to 450°C by mCVD, for example, JP-A-2018-140352 and JP-A-2018-172793 can be referred to as mCVD and an apparatus thereof.

Fig. 4 is a schematic view of a film forming apparatus for an insulating layer in a method for manufacturing a heat dissipation substrate. The film forming apparatus includes two atomizers, a mixing chamber, and a film forming machine which are connected with a silicone tube.

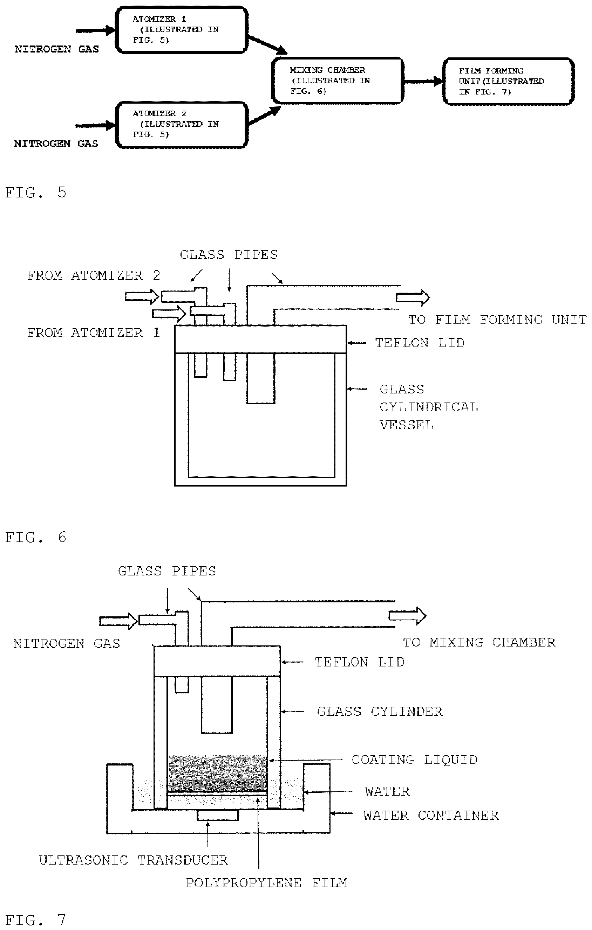

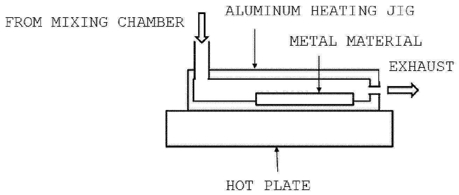

Fig. 5 is a schematic view of an atomizer in the film forming apparatus for an insulating layer in a method for manufacturing a heat dissipation substrate. The atomizer includes a vessel for containing a coating liquid and an ultrasonic generator including an ultrasonic transducer. The vessel includes a glass cylinder, a lid made of Teflon (registered trademark), and a bottom made of a polypropylene film. The lid is provided with two glass pipes penetrating therethrough. A first pipe is provided for sending a carrier gas (nitrogen) for conveying the mist into the vessel, and a second pipe is provided for sending the mist generated in the vessel and the carrier gas to the mixing chamber. The vessel is placed in the ultrasonic generator together with water, and the ultrasonic wave generated by the ultrasonic transducer is transmitted to the coating liquid via water and the polypropylene film, whereby the coating liquid is formed into mist (atomized).

Fig. 6 is a schematic view of a mixing chamber in the film forming apparatus for an insulating layer in a method for manufacturing a heat dissipation substrate. The mixing chamber includes a glass vessel and a lid made of Teflon (registered trademark). The lid is provided with three glass pipes penetrating therethrough. Among the three pipes, two pipes are respectively connected to two atomizers with a silicone tube, and one pipe provided at the center is connected to a film forming unit with a silicone tube. The mist generated in the atomizer is conveyed to the film forming unit via the mixing chamber. This mixing chamber is mainly used to mix the mist generated in separate atomizers.

Fig. 7 is a schematic view of a film forming unit in a film forming apparatus for an insulating layer in a method for manufacturing a heat dissipation substrate. The film forming unit includes an aluminum jig connected from the mixing chamber, and a hot plate. The jig is connected to the mixing chamber with a silicone tube, and is provided for heating the mist and the metal material 1. When the heated mist passes over the metal base material, the mist chemically reacts on the base material to form an insulating film. The above-described hot plate is provided for heating the jig.

The carrier gas is preferably an inert gas that does not contain oxygen at 10,000 ppm or more (volume ratio) in order to suppress oxidation of the surface of the metal material 1.

As described above, by forming a coating liquid containing a salt or a complex of aluminum into fine droplets and reacting the droplets on the metal material 1, irregularities on the surface of the metal material 1 can be filled, the surface roughness Ra3 can be set to 0.3 um or less, and the insulating layer 2 having a low porosity of 10% or less can be obtained.

In the above film forming method, it is preferable that the coating liquid contains an aluminum compound in an amount of 0.2 wt% or more and 20 wt% or less, in the first step, the aluminum compound in the coating liquid is heated at a temperature of 230°C or more and 450°C or less to form the first insulating layer 21, and in the second step, the heated aluminum compound is reacted with water and/or ozone to form the second insulating layer 22. As described above, by controlling the concentration of the aluminum compound and using an appropriate oxygen source in the first step and the second step, it is possible to obtain the insulating layer 2 having an appropriate amorphous carbon content.

<Heat dissipation circuit board>

Fig. 2 is a schematic cross-sectional view illustrating a configuration example of the heat dissipation circuit board of the present embodiment. In the heat dissipation circuit board 300, the conductive metal layer 3 is provided on the surface of the insulating layer 2 of the heat dissipation substrate 100 on a side opposite to the metal material 1. The heat dissipation circuit board 300 is mainly used for dissipating heat generated from a circuit, a semiconductor chip, and the like, and includes the metal material 1, the insulating layer 2, and the conductive metal layer 3. The conductive metal layer 3 is provided for an electrode of a semiconductor chip and the like, and the metal material 1 is provided to dissipate heat generated from a semiconductor chip and the like. The insulating layer 2 is provided to insulate the conductive metal layer 3 and the metal material 1 from each other.

<Conductive metal layer>

The material for the conductive metal layer 3 is not particularly limited as long as it is a metal commonly used as an electrode. Examples of the materials for the conductive metal layer 3 include copper, silver, chromium, ITO, and IZO. The thickness of the electrode is not particularly limited, and may be, for example, 0.5 um or more and 0.5 mm or less.

In the heat dissipation circuit board 300, it is required that the conductive metal layer 3 and the metal material 1 are not electrically connected, and as a confirmation method thereof, it is considered to be favorable if a current of 1 mA or more does not flow when a DC voltage of 5 V is applied to the metal material 1 and the conductive metal layer 3.

The method for forming the conductive metal layer 3 is not particularly limited, and examples thereof include a method in which a copper foil processed into a circuit shape is pasted, etching into a circuit shape is performed after plating, or etching into a circuit shape is performed after deposition of the conductive metal layer 3.

An adhesive layer, an anchor layer, and the like may be provided between the insulating layer 2 and the conductive metal layer 3, if necessary.

<Heat dissipation member>

Fig. 3 is a schematic cross-sectional view illustrating a configuration example of the heat dissipation member of the present embodiment. The heat dissipation circuit board 300 is preferably used as a heat dissipation member 500 in which the metal material 1 is bonded to the heat sink 5 using an adhesive or grease 4 in a case where higher heat dissipation properties are desired. In the heat dissipation member 500, the heat sink 5 is bonded to the metal material 11 of the heat dissipation substrate 100 via the adhesive or grease 4. As the adhesive or grease 4, it is preferable to use highly thermal conductive one.

As the general method of using the heat dissipation circuit board 300, a heat generator such as a semiconductor chip that generates heat when electrified is provided on the conductive metal layer 3, and heat generated by the heat generator is dissipated to the metal material 1 via the insulating layer 2.

EXAMPLES

Hereinafter, the present invention will be described more specifically with reference to Examples and Comparative Examples.

<Manufacturing Example>

<Preparation of coating liquid>

Coating liquids were prepared using the raw materials and blending ratios (% by mass) presented in Table 1.

[Table 1]

| | | Blending amount (wt%) | | | | | | | | |
|---|---|---|---|---|---|---|---|---|---|---|
| | | Coating liquid A | Coating liquid B | Coating liquid C | Coating liquid D | Coating liquid E | Coating liquid F | Coating liquid G | Coating liquid H | Coating liquid I |
| Aluminum salt/ complex | Al (acac) 3 | 8.0 | 8.0 | | | | | | | |
| | Al (iPr) 2Eacac | | | 0.5 | 0.5 | | | | | |
| | Al (Eacac) 3 | | | | | 2.0 | 2.0 | | | |
| | Al (Eacac)2acac | | | | | | | 1.0 | 1.0 | |
| Oxygen source | Water | | 10.0 | | 10.0 | | 10.0 | | 10.0 | 100.0 |
| Solvent | Toluene | 92.0 | 82.0 | | | 98.0 | | | | |
| | Acetonitrile | | | 99.5 | 89.5 | | | 99.0 | | |
| | Methanol | | | | | | 88.0 | | 89.0 | |

In Table 1, Al(acac)3 denotes aluminum tris(acetylacetonate) ("Aluminum Chelate A", manufactured by Kawaken Fine Chemicals Co., Ltd.);

Al(iPr)2Eacac denotes aluminum ethyl acetoacetate diisopropylate ("ALCH", manufactured by Kawaken Fine Chemicals Co., Ltd.);
Al(Eacac)3 denotes aluminum tris(ethyl acetoacetate) ("ALCH-TR", manufactured by Kawaken Fine Chemicals Co., Ltd.); and
Al(Eacac)2acac denotes aluminum monoacetylacetonate bis(ethyl acetoacetate) ("Aluminum Chelate D", manufactured by Kawaken Fine Chemicals Co., Ltd.).

<Example 1>

<Formation of insulating layer on metal material>

<<Apparatus preparation>>

An insulating layer was formed on a metal material by the following method using the film forming apparatus (mCVD apparatus) illustrated in Figs. 4 to 7. A polypropylene film was fixed at a position 1 cm from the bottom of a glass cylinder (13 cm in diameter and 15 cm in height) with an O-ring and a caulking agent. A Teflon (registered trademark) lid was provided on the top of the cylinder, two holes were made in the lid, and glass pipes for supplying nitrogen gas and for conveying mist were inserted into the holes. The cylinder was immersed in a water bath, and three ultrasonic transducers (Ultrasonic Atomizer Unit HMC-2401; manufactured by HONDA ELECTRONICS CO., LTD.) were installed directly below the polypropylene. The above was used as an atomizer, and two atomizers were prepared. A Teflon (registered trademark) lid was provided in a glass cylindrical vessel, three holes were made in the lid, and glass pipes for connecting the atomizer (two pipes) and for connecting the film forming unit were inserted into the holes. The above was used as a mixing chamber, and the mixing chamber was connected to the two atomizers with a 1.5 m silicone tube. An openable aluminum heating jig was placed on a hot plate, and metal materials (30 × 30 × 0.5 mm and 30 × 5 × 0.5 mm) were set thereon. The distance between the upper surface of the metal material and the top surface on the inner side of the jig was 1 mm. The above was used as a film forming unit, and the film forming unit was connected to the mixing chamber with a 1.5 m silicone tube. A coating liquid 1 (200 mL) was poured into an atomizer 1, and a coating liquid 2 (200 mL) was poured into an atomizer 2. A nitrogen gas (oxygen concentration: 1 ppm or less) was caused to flow at 11 L/min (5.5 L/min per atomizer) for 10 minutes from the nitrogen gas supply pipe of the atomizer to the exhaust hole of the film forming unit. Thereafter, the metal materials were heated with a hot plate until the temperature of the metal material reached 360°C.

<<First step>>

After it was confirmed that the temperature of the metal material was stabilized at 360°C, the ultrasonic transducer of the atomizer 1 was operated to form the coating liquid 1 into mist for 5 minutes (first insulating layer film forming time), thereby forming the first insulating layer.

<<Second step>>

The ultrasonic transducer of the atomizer 1 was stopped, and at the same time, the ultrasonic transducer of the atomizer 2 was operated to form the coating liquid 2 into mist for 15 minutes (second insulating layer film forming time), thereby forming the second insulating layer continuously to the formation of the first insulating layer.

<<Manufacturing conditions>>

The ultrasonic transducer was operated at a frequency of 2.4 MHz, and the supply power was set at a DC voltage of 24 V and a current of 0.6 A. The coating liquid 1, the coating liquid 2, and the metal material used are presented in Table 2.
The samples obtained above were evaluated as follows.

<Measurement of composition of insulating layer>

The weights of aluminum atoms, oxygen atoms, and carbon atoms per unit volume and their ratios were calculated by dynamic SIMS. PHI ADEPT (manufactured by ULVAC-PHI, Inc.) was used as a measuring instrument, Cs+ was used as the primary ion species, the primary accelerating voltage was 5.0 kV, and the detection region was 45 × 45 um. A sample in which a 1 um metal oxide was formed on glass instead of the metal material of Example 1 was prepared.

The measurement was performed at central portion of the sample in the depth direction, and the point where silicon was detected was defined as a depth of 1 um. The weight ratio among the three atoms was calculated from the secondary ionic intensity, relative sensitivity coefficient, and atomic weight of each of aluminum, oxygen, and carbon atoms (insulating layer main composition). The ratio of impurities was calculated by comparing the total value of the three atomic weights per unit volume with the specific gravity of the insulating layer, and the content of the main composition (main composition content) was calculated from the ratio of impurities.

<Confirmation of carbon atom>

The confirmation of the carbon atoms of the insulating layer was performed using a micro Raman spectrometer (XPLORA; manufactured by HORIBA, Ltd.). The analysis conditions were as follows: laser wavelength: 532 nm, laser power level: 0.5 mW, objective lens: 100 times, exposure time: 12 seconds, number of exposures: 100 times, and grating level: 900. As a result of Raman spectroscopy, in all the insulating layers of Examples 1 to 13, the peak at 1,200 to 1,700 (/cm) (amorphous carbon) of the Raman shift appeared significantly stronger than the peak at 2,900 to 3,000 (/cm) (hydrocarbon), and thus it was found that most of the carbon atoms existed as amorphous carbon.

<Measurement of film thickness of insulating layer>

The film thickness of the insulating layer was measured using a reflectance spectroscopic film thickness meter (F20; manufactured by Filmetrics, INC.) after each insulating layer was formed on chromium glass instead of the metal material of Example 1. It was assumed that the insulating layer formed on the chromium glass and the insulating layer formed on the metal material had the same film thickness. In addition, in order to obtain an accurate film thickness, it is necessary to calculate the film thickness based on the data of the refractive index. As for the refractive index, the same sample was observed using an ellipsometer (UVISEL Plus; (manufactured by HORIBA, Ltd.), and the refractive index was previously calculated. Note that, in Comparative Examples 1 to 4 described later, since the insulating layer was not transparent, the cross section was formed by an ion milling method, a micrograph of the cross section was taken with a scanning electron microscope, and then the film thickness was measured.

<Measurement of surface roughnesses of metal material and insulating layer>

The surface roughness (Ra1) of the metal material and the surface roughness (Ra3) of the second insulating layer were measured using a contact-type surface roughness meter (DektakXT-S; manufactured by Bruker Japan K.K.). The surface roughness was measured by 0.5 mm at the central portion of the base material, and the arithmetic mean roughness was calculated. Note that the surface roughness (Ra2) of the first insulating layer was measured by taking out the sample at the time when the first insulating layer of Example 1 was formed.

<Porosity>

A cross section of a 30 mm × 30 mm sample of the insulating layer was formed by an ion milling method, and a cross-sectional electron micrograph of 500 nm × 500 nm or more was obtained. The area (S1) of the insulating layer (metal oxide layer) in the electron micrograph and the area of the space (S2) in the same electron micrograph were calculated, and the porosity was determined from the following equation. As for the area of the space, the areas of all spaces of which long sides were 10 nm or more were calculated and summed.

$$\texttt{Porosity = S2 × 100/S1 (\%)}$$

Those having a porosity of 10% or less were evaluated as good "O", and those having a porosity of more than 10% were evaluated as not acceptable "×".

<Adhesion>

The adhesion was evaluated by the presence or absence of peeling off between the metal material and the insulating layer after a cold and heat resistance test. Specifically, using a TSA-103ES-W thermal shock testing machine manufactured by ESPEC Co., Ltd., the 30 mm × 30 mm sample was subjected to 100 cycles of cold and heat resistance test in which one cycle consisted of cooling at -40°C for 35 minutes and heating at 200°C for 35 minutes. In accordance with JIS K5400-8.5, 11 scratches (100 squares) were made in each of the vertical and horizontal directions at an interval of 1 mm on the insulating layer after the test, and then, a piece of scotch tape was attached to the sample and then peeled off, and the peeling state of the insulating layer was observed to evaluate the presence or absence of peeling off. Those without peeling off were evaluated as good "O", those with peeling off but less than 20% in 100 squares were evaluated as acceptable "Δ", and those with peeling off of 20% or more in 100 squares were evaluated as not acceptable "×".

<Insulation properties>

A circular main electrode having a diameter of 10 mm as a conductive metal layer was formed on the 30 mm × 30 mm sample of the insulating layer using a silver paste, whereby a heat dissipation circuit board was fabricated. Using the obtained heat dissipation circuit board, the volume resistivity was measured by applying a DC voltage of 400 V to between the metal material and the main electrode and measuring the current using 5450 High Resistance Meter manufactured by ADC Corporation. Those having a volume resistivity of 2,000 GΩ·cm or more were evaluated as good "O", those having a volume resistivity of 1,000 GΩ·cm or more and less than 2,000 GΩ·cm were evaluated as acceptable "Δ", and those having a volume resistivity of less than 1,000 GΩ·cm were evaluated as not acceptable "×". In Table 2, the unit of the volume resistivity is TΩ (= 1,000 GΩ).

<Warpage>

A sample having a thickness of 0.5 mm, a length of 30 mm, and a width of 5 mm was heated at 140°C for 10 minutes so that the metal material 1 was in contact with the hot plate (so that the insulating layer was on the upper side). A short side of the sample was defined as a fixed end and a short side on the opposite side was defined as a free end. The fixed end was pressed against the hot plate, and then a maximum distance (V: mm) between the hot plate and the free end was measured with a metal ruler. The warpage of the heat dissipation substrate (the ratio of the warpage to the length of the sample) was calculated by the following equation.

$$\mathtt{Warpage\ =\ V/30\ \times\ 100\ (\%)}$$

Those having a warpage of less than 2% were evaluated as good "O", those having a warpage of 2% or more and 5% or less were evaluated as acceptable "Δ", and those having a warpage of more than 5% were evaluated as not acceptable "×". For example, in a case where V is 2 mm, warpage is 2/30 × 100 (= 6.7)%.

<Thermal conductivity (heat dissipation properties)>

In a dry glove box purged with nitrogen contained in a cylinder, about 10 grains of ammonium acetate (melting point: 112°C) that was not deliquesced were placed on the 30 mm × 30 mm sample of the insulating layer, and the sample was placed on a hot plate at 120±3°C with the metal material facing down. An enlarged picture of the manner in which ammonium acetate was melting was taken using a CCD camera, and the time T1 from when the sample was placed on the hot plate until the ammonium acetate completely became liquid was measured. Those having the time T1 of 120 seconds or less were evaluated as good "O", those having the time T1 of less than 120 seconds and 150 seconds or less were evaluated as acceptable "Δ", and those having the time T1 of more than 150 seconds were evaluated as not acceptable "×".

<Confirmation of formation of conductive metal layer>

A silver paste (DOTITE FA-451A; manufactured by Fujikura Kasei Co., Ltd.) was applied near the center of the 30 mm × 30 mm sample of the insulating layer by screen printing in a size of 2 mm × 20 mm (thickness: 20 to 30 $\mu$m), heated at 150°C for 30 minutes, and then further heated at 200°C for 24 hours to form an electrode as a conductive metal layer, whereby a heat dissipation circuit board was fabricated. A voltage of 5 V was applied to both ends of the long side of the electrode, and the electrical resistance was measured. Those having an electrical resistance of $5 \times 10^{-3}$ Ω·cm or less were evaluated as good "O", and those having an electrical resistance of more than $5 \times 10\text{-}3$ Ω·cm were evaluated as not acceptable "×". It was evaluated as "×" in a case where cracking occurred in the electrode as well. It was evaluated as acceptable "Δ" in a case where cracking of the conductive metal layer was visually confirmed although the electrical resistance was $5 \times 10^{-3}$ Ω·cm or less.

<Confirmation of electrical connection between conductive metal layer and metal material>

Using the heat dissipation circuit board obtained above, a voltage of 5 V was applied to the electrode formed with a silver paste and the metal material. Those in which the current flowed was 1 mA or less were evaluated as good "O", and those in which the current flowed was more than 1 mA were evaluated as not acceptable "×".

<Examples 2 to 4, 8, and 13>

Samples were prepared by the same operation as in Example 1 except that the conditions for forming the insulating layer of Example 1 were changed to the conditions presented in Table 2 (metal material, coating liquid 1, coating liquid 2, metal material temperature, oxygen concentration in nitrogen gas, first insulating layer film forming time, second insulating layer film forming time), and the above evaluation was performed. The results are presented in Table 2.

<Examples 5 to 7 and 9 to 12>

The same operation as in Example 1 was performed except that, in the conditions presented in Table 2 (metal material, coating liquid 1, coating liquid 2, metal material temperature, oxygen concentration in nitrogen gas, first insulating layer film forming time) and in the above-described <<Second step>>, the conditions described in the apparatus preparation of Example 1 was changed such that the ultrasonic transducer of the atomizer 2 was simultaneously operated without stopping the ultrasonic transducer of the atomizer 1, the coating liquid 2 was formed into mist for the time presented in Table 2 (second insulating layer film forming time), the second insulating layer was formed continuously to the formation of the first insulating layer film. In this second step, the atomizer 1 and the atomizer 2 are simultaneously activated, and two kinds of coating liquid mists are mixed in the mixing chamber, and then film formation is performed. The samples obtained above were evaluated in the same manner as in Example 1. The results are presented in Table 2.

<Comparative Example 1>

A heat dissipation substrate was obtained with reference to Example 1 of Patent Document 1. Specifically, an aluminum metal material (30 mm $\times$ 30 mm) having a thickness of 0.2 mm and an aluminum nitride (AlN) metal oxide substrate (ceramic substrate; 30 mm $\times$ 30 mm) having a thickness of 635 um were stacked with a brazing filler metal foil (thickness 12 um) formed of an Al-Cu-Mg clad foil interposed therebetween, and joined by being heated and pressed using a hot press in an atmosphere of 630°C and 6.0 $\times$ 10-4 Pa. The obtained sample was evaluated as described in Example 1. The results are presented in Table 3.

<Comparative Example 2>

A heat dissipation substrate was obtained with reference to Example 1 of Patent Document 2. Specifically, a thermosetting resin composed of a bisphenol A epoxy resin and 3- or 4-methyl-1,2,3,6-tetrahydrophthalic anhydride was applied onto one surface of an aluminum metal material (30 mm $\times$ 30 mm) having a thickness of 0.3 mm by 20 $\mu$m, and cured by being heated at 230°C for 3 hours. After that, the surface not coated with the thermosetting resin was anodized in an oxalic acid aqueous solution to obtain an 80 $\mu$m alumite layer. The thickness of the alumite layer was determined by forming a cross section by an ion milling method, taking a micrograph using a scanning electron microscope, and measuring the film thickness. The obtained sample was evaluated as described in Example 1. The results are presented in Table 3.

<Comparative Example 3>

A heat dissipation substrate was obtained with reference to Patent Document 3. Specifically, alumina powder (6103; manufactured by METCO) was thermally sprayed on one surface of a copper metal material (30 mm $\times$ 30 mm) having a thickness of 0.5 mm at 1,650°C so that the metal oxide layer had a thickness of 95 um. The thickness of the thermally sprayed layer was determined by forming a cross section by an ion milling method, taking a micrograph using a scanning electron microscope, and measuring the film thickness. The obtained sample was evaluated as in Example 1. The results are presented in Table 3.

<Comparative Example 4>

A heat dissipation substrate was obtained with reference to Example 1 of Patent Document 4. Specifically, a metal oxide layer was formed on one surface of a SUS316 metal material (30 mm $\times$ 30 mm) having a thickness of 0.5 mm using a 1 wt% acetylacetonate tin(II) methanol solution (referred to as coating liquid J in Table 3) as the coating liquid at a hot plate temperature of 450°C using the film forming apparatus used in Example 1. The thickness of the metal oxide layer was determined by forming a cross section by an ion milling method, taking a micrograph using a scanning electron microscope, and measuring the film thickness. The obtained sample was evaluated as described in Example 1. The results are presented in Table 3.

<Comparative Example 5>

<Formation of insulating layer on metal material>

<<Apparatus preparation>>

An insulating layer was formed on a metal material by the following method using the film forming apparatus (mCVD apparatus) illustrated in Fig. 4. A polypropylene film was fixed at a position 1 cm from the bottom of a glass cylinder (13 cm in diameter and 15 cm in height) with an O-ring and a caulking agent. A Teflon (registered trademark) lid was provided on the top of the cylinder, two holes were made in the lid, and glass pipes for supplying nitrogen gas and for conveying mist were inserted into the holes. The cylinder was immersed in a water bath, and three ultrasonic transducers (Ultrasonic Atomizer Unit HMC-2401; manufactured by HONDA ELECTRONICS CO., LTD.) were installed directly below the polypropylene. The above was used as an atomizer, and two atomizers were prepared. A Teflon (registered trademark) lid was provided in a glass cylindrical vessel, three holes were made in the lid, and glass pipes for connecting the atomizer (two pipes) and for connecting the film forming unit were inserted into the holes. The above was used as a mixing chamber, and the mixing chamber was connected to the two atomizers with a 1.5 m silicone tube. An openable aluminum heating jig was placed on a hot plate, and metal materials (30 × 30 × 0.5 mm and 30 × 5 × 0.5 mm) were set thereon. The distance between the upper surface of the metal material and the top surface on the inner side of the jig was 1 mm. The above was used as a film forming unit, and the film forming unit was connected to the mixing chamber with a 1.5 m silicone tube. A coating liquid 1 (200 mL) was poured into an atomizer 1, and a coating liquid 2 was not poured into an atomizer 2. A nitrogen gas (oxygen concentration: 1 ppm or less) was caused to flow at 11 L/min (5.5 L/min per atomizer) for 10 minutes from the nitrogen gas supply pipe of the atomizer to the exhaust hole of the film forming unit. Thereafter, the metal materials were heated with a hot plate until the temperature of the metal material reached 360°C.

<<Formation of insulating layer>>

After it was confirmed that the temperature of the metal material was stabilized at 360°C, the ultrasonic transducer of the atomizer 1 was operated to form the coating liquid 1 into mist for 22 minutes (second insulating layer film forming time), thereby forming an insulating layer. Since the insulating layer is one layer, it is described as a second insulating layer in Table 3.

<<Manufacturing conditions>>

The ultrasonic transducer was operated at a frequency of 2.4 MHz, and the supply power was set at a DC voltage of 24 V and a current of 0.6 A. The coating liquid 1 and the metal material used are presented in Table 3. The obtained sample was evaluated as described in Example 1. The results are presented in Table 3.

[Table 2]

| Example | 1 | 2 | 3 | 4 | 5 | 6 | 7 | 8 | 9 | 10 | 11 | 12 | 13 |
|---|---|---|---|---|---|---|---|---|---|---|---|---|---|
| Kind of metal material | Copper | | | | | | | Aluminum | | Cu60Mo40 | Al96Mg4 | AlCu5C0.3 | Copper |
| Composition of metal material (%) | Cu = 100 | | | | | | | Al = 100 | | Cu/Mo = 60/40 | Al/Mg = 96/4 | Al/Cu/C = 94.7/5/0.3 | Cu = 100 |
| Surface roughness of metal material (Ra1: μm) | 0.05 | 0.05 | 0.30 | 0.40 | 0.05 | 0.30 | 0.60 | 0.15 | 0.13 | 0.10 | 0.10 | 0.10 | 1.50 |
| Metal material thickness (mm) | 0.5 | 1.5 | 5.0 | 20.0 | | 1.5 | | 1.5 | 20.0 | | 1.5 | | 0.5 |
| Coating liquid 1 | A | C | E | G | A | E | A | A | A | A | A | A | A |
| Coating liquid 2 | B | D | F | H | — | — | — | B | — | — | — | — | B |
| Metal material temperature (°C) | 360 | 390 | 390 | 390 | 320 | 360 | 390 | 360 | 360 | 410 | 360 | 260 | 360 |
| Oxygen concentration in nitrogen gas (ppm) | 1 or less | 1000 | 100 | 10 | 1 or less | 1 or less | 1 or less | 1 or less | 1 or less | 1 or less | 1 or less | 100 | 1 or less |
| First step film forming time (min) | 5 | 10 | 5 | 10 | 5 | 10 | 5 | 5 | 5 | 5 | 5 | 5 | 5 |
| Second step film forming time (min) | 15 | 30 | 30 | 20 | 22 | 30 | 60 | 15 | 22 | 22 | 22 | 22 | 15 |
| First insulating layer main composition (Al/O/C: wt) | 44/43/13 | 36/55/9 | 45/41/14 | 43/45/12 | 43/43/14 | 44/41/15 | 45/44/11 | 44/42/14 | 45/44/11 | 48/46/6 | 44/46/10 | 38/44/18 | 44/42/14 |

17

| Example | 1 | 2 | 3 | 4 | 5 | 6 | 7 | 8 | 9 | 10 | 11 | 12 | 13 |
|---|---|---|---|---|---|---|---|---|---|---|---|---|---|
| First insulating layer main composition content (wt%) | 93 | 94 | 96 | 95 | 93 | 94 | 96 | 94 | 96 | 97 | 94 | 92 | 92 |
| Second insulating layer main composition (Al/O/C: wt) | 49/49/2 | 35/64/1 | 48/50/2 | 46/53/1 | 47/50/3 | 48/49/3 | 48/51/1 | 48/50/2 | 49/50/1 | 52/48/0 | 49/50/1 | 46/50/4 | 50/49/1 |
| Second insulating layer main composition content (wt%) | 98 | 99 | 99 | 98 | 97 | 99 | 99 | 98 | 99 | 100 | 98 | 96 | 98 |
| First insulating layer surface roughness (Ra2: μm) | 0.04 | 0.05 | 0.26 | 0.35 | 0.05 | 0.26 | 0.58 | 0.15 | 0. 13 | 0.10 | 0.09 | 0.10 | 1.46 |
| Second insulating layer surface roughness (Ra3: μm) | 0.02 | 0.01 | 0.06 | 0.16 | 0.01 | 0.08 | 0.01 | 0.05 | 0.06 | 0.00 | 0.01 | 0.01 | 0.78 |
| First insulating layer film thickness (μm) | 0.12 | 0.02 | 0. 18 | 0.16 | 0.10 | 0.04 | 0.15 | 0.11 | 0.14 | 0.17 | 0. 13 | 0.05 | 0.11 |
| Second insulating layer film thickness (μm) | 1.54 | 0.62 | 3.60 | 2.27 | 1.28 | 4.23 | 9.36 | 1.62 | 1.92 | 2.62 | 1.84 | 0.86 | 1.92 |
| First insulating layer porosity (%) | 0 | 0 | 0 | 0 | 0 | 0 | 0 | 0 | 0 | 0 | 0 | 0 | 0 |

| Example | 1 | 2 | 3 | 4 | 5 | 6 | 7 | 8 | 9 | 10 | 11 | 12 | 13 |
|---|---|---|---|---|---|---|---|---|---|---|---|---|---|
| Second insulating layer porosity (%) | 0 | 0 | 0 | 0 | 0 | 0 | 0 | 0 | 0 | 0 | 0 | 0 | 0 |
| Adhesion | ○ | ○ | ○ | ○ | ○ | ○ | ○ | ○ | ○ | ○ | ○ | ○ | ○ |
| Insulation properties | ○ | ○ | ○ | ○ | ○ | ○ | ○ | ○ | ○ | ○ | ○ | ○ | ○ |
| Insulation properties (numerical value: $T\Omega cm$) | 18000 | 1300 | 22000 | 36000 | 15000 | 20000 | 15000 | 17000 | 19000 | 33000 | 1200 | 110 | 8 |
| Warpage | ○ | ○ | ○ | ○ | ○ | ○ | ○ | ○ | ○ | ○ | ○ | ○ | ○ |
| Warpage (numerical value: %) | 0 | 0 | 0 | 0 | 0 | 0 | 0 | 0 | 0 | 0 | 0 | 0 | 0 |
| Thermal conductivity | ○ | ○ | ○ | ○ | ○ | ○ | ○ | ○ | ○ | ○ | ○ | ○ | ○ |
| Thermal conductivity (numerical value: s) | 20 | 6 | 38 | 35 | 12 | 32 | 56 | 25 | 53 | 30 | 19 | 11 | 26 |
| Formation of conductive layer | ○ | ○ | ○ | ○ | ○ | ○ | ○ | ○ | ○ | ○ | ○ | ○ | Δ |
| Electrification of conductive layer | ○ | ○ | ○ | ○ | ○ | ○ | ○ | ○ | ○ | ○ | ○ | ○ | ○ |

EP 4 495 991 A1

[Table 3]

| Comparative Example | 1 | 2 | 3 | 4 | 5 |
|---|---|---|---|---|---|
| Kind of metal material | Aluminum | Aluminum | Copper | SUS316 | Copper |
| Composition of metal material (%) | Al - 100 | Al - 100 | Cu - 100 | Fe/Cr/Ni/Mo - 67.5/18/12/2.5 | Cu - 100 |
| Surface roughness of metal material (Ra1: μm) | 0.14 | 0.15 | 0.05 | 7.40 | 0.05 |
| Metal material thickness (mm) | 0.2 | 0.3 | 0.5 | 0.5 | 0.5 |
| Coating liquid 1 | - | - | - | J | B |
| Coating liquid 2 | - | - | - | I | - |
| Manufacturing method | Hot pressing | Anodic oxidation | Thermal spraying | mCVD | mCVD |
| Insulating layer | Aluminum nitride | Alumina | Alumina | - | - |
| Metal material temperature (°C) | - | - | - | 450 | 360 |
| Oxygen concentration in nitrogen gas (ppm) | - | - | - | 1 or less | 1 or less |
| First step film forming time (min) | - | - | - | 5 | 5 |
| Second step film forming time (min) | - | - | - | 22 | 15 |
| First insulating layer main composition (wt) | - | - | - | Sn/O/C - 75/22/3 | - |
| First insulating layer main composition content (wt%) | - | - | - | 90 | - |
| Second insulating layer main composition (wt) | Al/N - 67/33 | Al/O - 57/43 | Al/O - 54/46 | Sn/O/C - 75/25/0 | Al/O/C - 48/80/2 |
| Second insulating layer main composition content (wt%) | 100 | 100 | 100 | 99 | 98 |
| First insulating layer surface roughness (Ra2: μm) | - | - | - | 7.40 | - |
| Second insulating layer surface roughness (Ra3: μm) | 8.20 | 0.14 | 35.00 | 6.90 | 0.02 |
| First insulating layer film thickness (μm) | - | - | - | 0.08 | - |
| Second insulating layer film thickness (μm) | 635.00 | 80.00 | 95.00 | 0.68 | 1.55 |
| First insulating layer porosity (%) | - | - | - | 0.0 | - |
| Second insulating layer porosity (%) | 36.0 | 18.0 | 45.0 | 0.0 | 0.0 |
| Adhesion | ○ | ○ | ○ | x | x |
| Insulation properties | ○ | Δ | ○ | x | ○ |
| Insulation properties (numerical value: GΩcm) | 1500000 | 1100 | 200000 | 0.0001 | 1600000 |
| Warpage | x | ○ | x | ○ | Δ |
| Warpage (numerical value: %) | 15 | 0 | 8 | 0 | 4 |
| Thermal conductivity | x | x | × | × | ○ |

(continued)

| Comparative Example | 1 | 2 | 3 | 4 | 5 |
|---|---|---|---|---|---|
| Thermal conductivity (numerical value: s) | 760 | 250 | 360 | 240 | 18 |
| Formation of conductive layer | ○ | ○ | ○ | ✕ Cracking of electrode | ○ |
| Electrification of conductive layer | ○ | x | ○ | x | ○ |

Comparative Example 1 is a heat dissipation substrate fabricated by a hot pressing method, which is common as a manufacturing method for a heat dissipation substrate. The insulating layer of the heat dissipation substrate obtained in Comparative Example 1 had a low porosity and was thick, and thus had a larger warpage and a lower thermal conductivity than those in Examples.

Comparative Example 2 is a heat dissipation substrate fabricated by an anodic oxidation method. The heat dissipation substrate obtained in Comparative Example 2 not only exhibited lower insulation properties but also exhibited insufficient heat dissipation properties as compared with those of Examples. As for electrification of the conductive layer, three samples out of five samples were electrified.

Comparative Example 3 is a heat dissipation substrate fabricated by a thermal spraying method. The heat dissipation substrate obtained in Comparative Example 3 had a low porosity and was thick, and thus had a larger warpage and a lower thermal conductivity than those in Examples.

Comparative Example 4 is a heat dissipation substrate fabricated by a mCVD method. The heat dissipation substrate obtained in Comparative Example 4 did not exhibit sufficient adhesion, insulation properties, and thermal conductivity because the composition of the insulating layer and the kind of the metal material 1 were outside the scope of the claims of the present patent. Since the surface roughness (Ral) of the metal material was also large, cracking occurred in the electrode during formation of the conductive metal layer.

Comparative Example 5 is a heat dissipation substrate fabricated by a mCVD method as in Comparative Example 4, and is a heat dissipation substrate excluding the first insulating layer. Although the insulation properties were higher than that of Comparative Example 4, adhesion was significantly low and warpage occurred because the first insulating layer was not provided.

DESCRIPTION OF REFERENCE SIGNS

1       Metal material
2       Insulating layer
21      First insulating layer
22      Second insulating layer
3       Conductive metal layer
4       Adhesive or grease
5       Heat sink
100     Heat dissipation substrate
300     Heat dissipation circuit board
500     Heat dissipation member

**Claims**

1. A heat dissipation substrate comprising a metal material provided adjacent to one surface of an insulating layer, wherein

    a material of the metal material contains copper or a copper alloy, or aluminum or an aluminum alloy, and the metal material has a sheet shape having a thickness of 0.2 mm or more and 20 mm or less,
    the insulating layer includes:

        a first insulating layer provided adjacent to the metal material; and
        a second insulating layer provided adjacent to a surface of the first insulating layer on a side opposite to the metal material,

the first insulating layer and the second insulating layer are metal oxide layers different from each other,
the first insulating layer is a metal oxide layer containing 90 wt% or more of an aluminum oxide represented by a composition formula 1: AlxOyCz (where Al represents an aluminum atom, O represents an oxygen atom, and C represents a carbon atom; x, y, and z denote a weight ratio, x + y + z = 100, x is 30 or more and 50 or less, y is 40 or more and 60 or less, and z is 3 or more and 25 or less) and having a thickness of 0.01 um or more and 0.2 um or less and a porosity of 10% or less, and
the second insulating layer is a metal oxide layer containing 95 wt% or more of an aluminum oxide represented by a composition formula 2: AlxOyCz (where Al represents an aluminum atom, O represents an oxygen atom, and C represents a carbon atom; x, y, and z denotes a weight ratio, x + y + z = 100, x is 30 or more and 55 or less, y is 40 or more and 65 or less, and z is 0 or more and 10 or less) and having a thickness of 0.3 um or more and 30 um or less and a porosity of 10% or less.

2.  The heat dissipation substrate according to claim 1, wherein a volume resistivity of the insulating layer is 100 GΩ·cm or more.

3.  The heat dissipation substrate according to claim 1 or 2, wherein
in a test piece of a heat dissipation substrate in accordance with test methods of coil set and twist for sheets and strips of copper and copper alloys specified by Japan Copper Brass Association (JCBA) T-324:2011, the test piece having a thickness of 0.5 mm, a length of 30 mm, and a width of 5 mm, and having a short side as a fixed end and another short side on an opposite side as a free end, a warpage determined by pressing the fixed end of the test piece against a hot plate at 140°C for 10 minutes, then measuring a maximum distance (V (mm)) between the hot plate and a lower part of the free end, and substituting V into Calculation Formula 1 is 5% or less:

```
Calculation Formula 1: warpage = V/30 × 100 (%).
```

4.  The heat dissipation substrate according to claim 1 or 2, wherein

a surface roughness Ra1 of an interface of the metal material on a side adjacent to the insulating layer is 1.0 um or less, a surface roughness Ra2 of an interface of the first insulating layer on a side adjacent to the second insulating layer is 1.0 um or less, a surface roughness Ra3 of a surface of the second insulating layer on a side opposite to the first insulating layer is 0.3 um or less, and
Ra1 ≥ Ra2 ≥ Ra3 or Ra3 > Ra2 ≥ Ra1 is satisfied.

5.  A heat dissipation circuit board, wherein a conductive metal layer is provided on a surface of the insulating layer of the heat dissipation substrate according to claim 1 or 2, on a side opposite to the metal material.

6.  A heat dissipation member, wherein a heat sink is bonded to the metal material of the heat dissipation substrate according to claim 1 or 2 via an adhesive or a grease.

7.  A method for manufacturing the heat dissipation substrate according to claim 1 or 2, the method comprising a film forming step of reacting a coating liquid containing a salt or a complex of aluminum on a surface of the metal material separately in a first step and a second step to form the insulating layer.

8.  The method for manufacturing a heat dissipation substrate according to claim 7, wherein in the film forming step, a mist or a droplet obtained by atomizing or dropletizing the coating liquid is conveyed to a surface of the metal material with a carrier gas, and then the mist or the droplet is reacted separately in the first step and the second step in a temperature atmosphere of 230°C or more and 450°C or less.

9.  The method for manufacturing a heat dissipation substrate according to claim 7, wherein

the coating liquid contains 0.2 wt% or more and 20 wt% or less of an aluminum compound,
in the first step, the first insulating layer is formed by heating the aluminum compound in the coating liquid at 230°C or more and 450°C or less, and
in the second step, the second insulating layer is formed by reacting the heated aluminum compound with water and/or ozone.

FIG. 1

FIG. 2

FIG. 3

FIG. 4

ATOMIZER 1
(ILLUSTRATED IN
FIG. 5)

NITROGEN GAS

ATOMIZER 2
(ILLUSTRATED IN
FIG. 5)

NITROGEN GAS

MIXING CHAMBER
(ILLUSTRATED IN
FIG. 6)

FILM FORMING
UNIT(ILLUSTRATED
IN FIG. 7)

FIG. 5

GLASS PIPES

FROM ATOMIZER 2

FROM ATOMIZER 1

TO FILM FORMING UNIT

TEFLON LID

GLASS
CYLINDRICAL
VESSEL

FIG. 6

GLASS PIPES

NITROGEN GAS

TO MIXING CHAMBER

TEFLON LID

GLASS CYLINDER

COATING LIQUID

WATER

WATER CONTAINER

ULTRASONIC TRANSDUCER

POLYPROPYLENE FILM

FIG. 7

FROM MIXING CHAMBER    ALUMINUM HEATING JIG

METAL MATERIAL

EXHAUST

HOT PLATE

# EP 4 495 991 A1

<table>
<tr><td colspan="2" align="center">INTERNATIONAL SEARCH REPORT</td><td colspan="2">International application No.<br>**PCT/JP2023/009595**</td></tr>
</table>

**A. CLASSIFICATION OF SUBJECT MATTER**

*H01L 23/36*(2006.01)i; *B32B 15/04*(2006.01)i; *B32B 15/20*(2006.01)i; *H01L 23/12*(2006.01)i; *H05K 1/05*(2006.01)i
FI:   H01L23/36 C; H01L23/12 J; H05K1/05 B; H05K1/05 A; B32B15/04 B; B32B15/20

According to International Patent Classification (IPC) or to both national classification and IPC

**B. FIELDS SEARCHED**

Minimum documentation searched (classification system followed by classification symbols)
   H01L23/36; B32B15/04; B32B15/20; H01L23/12; H05K1/05

Documentation searched other than minimum documentation to the extent that such documents are included in the fields searched
   Published examined utility model applications of Japan 1922-1996
   Published unexamined utility model applications of Japan 1971-2023
   Registered utility model specifications of Japan 1996-2023
   Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 8-236885 A (TAISEI CO.,LTD.) 13 September 1996 (1996-09-13)<br>entire text, all drawings | 1-9 |
| A | JP 2017-110287 A (FLOSFIA INC.) 22 June 2017 (2017-06-22)<br>entire text, all drawings | 1-9 |
| A | WO 2011/151889 A1 (TOSHIBA MITSUBISHI-ELECTRIC INDUSTRIAL SYSTEMS CORP.) 08 December 2011 (2011-12-08)<br>entire text, all drawings | 1-9 |
| A | JP 2007-246337 A (DAI NIPPON PRINTING CO., LTD.) 27 September 2007 (2007-09-27)<br>entire text, all drawings | 1-9 |
| A | JP 2018-172793 A (FLOSFIA INC.) 08 November 2018 (2018-11-08)<br>entire text, all drawings | 1-9 |
| A | JP 2012-212788 A (DOWA HOLDINGS CO., LTD.) 01 November 2012 (2012-11-01)<br>entire text, all drawings | 1-9 |

☑ Further documents are listed in the continuation of Box C.      ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **29 March 2023** | **11 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

26

EP 4 495 991 A1

## INTERNATIONAL SEARCH REPORT

| | International application No. |
|---|---|
| | **PCT/JP2023/009595** |

**C.    DOCUMENTS CONSIDERED TO BE RELEVANT**

| Category* | Citation of document, with indication, where appropriate, of the relevant passages | Relevant to claim No. |
|---|---|---|
| A | JP 2019-070197 A (KOCHI PREFECTURAL PUBLIC UNIVERSITY CORP.) 09 May 2019 (2019-05-09) <br> entire text, all drawings | 1-9 |

Form PCT/ISA/210 (second sheet) (January 2015)

27

## INTERNATIONAL SEARCH REPORT
### Information on patent family members

International application No.

**PCT/JP2023/009595**

| Patent document cited in search report | | | Publication date (day/month/year) | Patent family member(s) | | | Publication date (day/month/year) |
|---|---|---|---|---|---|---|---|
| JP | 8-236885 | A | 13 September 1996 | (Family: none) | | | |
| JP | 2017-110287 | A | 22 June 2017 | (Family: none) | | | |
| WO | 2011/151889 | A1 | 08 December 2011 | US | 2013/0039843 | A1 | |
| | | | | entire text, all drawings | | | |
| JP | 2007-246337 | A | 27 September 2007 | (Family: none) | | | |
| JP | 2018-172793 | A | 08 November 2018 | US | 2018/0287169 | A1 | |
| | | | | entire text, all drawings | | | |
| JP | 2012-212788 | A | 01 November 2012 | (Family: none) | | | |
| JP | 2019-070197 | A | 09 May 2019 | (Family: none) | | | |

Form PCT/ISA/210 (patent family annex) (January 2015)

**REFERENCES CITED IN THE DESCRIPTION**

**Patent documents cited in the description**

- JP 2019067804 A
- JP 2012212788 A
- JP 2014207490 A
- JP 2018172793 A
- JP 2018140352 A